(19) Europäisches Patentamt / European Patent Office / Office européen des brevets

(11) **EP 4 386 481 A1**

(12) **EUROPEAN PATENT APPLICATION**

(43) Date of publication:
**19.06.2024 Bulletin 2024/25**

(21) Application number: **23195161.7**

(22) Date of filing: **04.09.2023**

(51) International Patent Classification (IPC):
**G03F 7/00** $^{(2006.01)}$

(52) Cooperative Patent Classification (CPC):
**G03F 7/706841; G03F 7/705**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **13.12.2022 KR 20220173797**

(71) Applicant: **Samsung Electronics Co., Ltd.**
**Suwon-si, Gyeonggi-do 16677 (KR)**

(72) Inventors:
• **PARK, Seong-Jin**
  **Suwon-si 16678 (KR)**
• **RHEE, Seon Min**
  **Suwon-si 16678 (KR)**
• **YANG, Jaewon**
  **Suwon-si 16678 (KR)**

(74) Representative: **Arnold & Siedsma**
**Bezuidenhoutseweg 57**
**2594 AC The Hague (NL)**

(54) **METHOD AND APPARATUS WITH SEMICONDUCTOR PATTERN CORRECTION**

(57) A processor-implemented method including generating a first corrected result image of a first desired pattern image using a backward correction neural network provided an input based on the first desired pattern image, the backward correction neural network performing a backward correction of a first process, generating a first simulated result image using a forward simulation neural network based on the first corrected result image, the forward simulation neural network performing a forward simulation of a performance of the first process, and updating the first corrected result image so that an error between the first desired pattern image and the first simulated result image is reduced.

FIG. 9

EP 4 386 481 A1

## Description

1. Field

The following description relates to a method and apparatus with a semiconductor pattern correction.

2. Description of Related Art

A typical semiconductor manufacturing process may include various detailed processes for processing a wafer. Within these wafer manufacturing processes, various error reducing techniques may be employed. For example, optical proximity correction (OPC) may be used for a develop process and process proximity correction (PPC) may be used for an etch process.

SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In a general aspect, here is provided a processor-implemented method including generating a first corrected result image of a first desired pattern image using a backward correction neural network based on the first desired pattern image, the backward correction neural network performing a backward correction of a first process, generating a first simulated result image by executing a forward simulation neural network based on the first corrected result image, the forward simulation neural network performing a forward simulation of a performance of the first process, and updating the first corrected result image so that an error between the first desired pattern image and the first simulated result image is reduced.

The method may include receiving input pattern images corresponding to a simulation input of the first process and output pattern images corresponding to a simulation output of the first process, performing a first initial training on the forward simulation neural network, based on the input pattern images and the output pattern images, to estimate the output pattern images from the input pattern images, and performing a second initial training on the backward correction neural network based on the input pattern images and the output pattern images so that the backward correction neural network estimates the input pattern images from the output pattern images.

The updating of the first corrected result image may include, in a state in which parameters of the forward simulation neural network are fixed, adjusting parameters of the backward correction neural network so that the error between the first desired pattern image and the first simulated result image is reduced.

The updating of the first corrected result image may include, in a state in which the parameters of the forward simulation neural network and the parameters of the backward correction neural network are fixed, adjusting pixels of the first corrected result image so that the error between the first desired pattern image and the first simulated result image is reduced.

The updating of the first corrected result image may include updating the first corrected result image based on gradient descent.

The method may include finalizing the first corrected result image based on a first result of iteratively updating the first corrected result image, generating a second corrected result image of a second desired pattern image using the backward correction neural network provided a first input based on the second desired pattern image, generating a second simulated result image using the forward simulation neural network provided a second input based on the second corrected result image, and updating the second corrected result image so that an error between the second desired pattern image and the second simulated result image is reduced.

The method may include finalizing the second corrected result image based on a second result of iteratively updating the second corrected result image, a first finalized version of the first corrected result image corresponding to an individual optimization result of the first desired pattern image, and a second finalized version of the second corrected result image corresponding to an individual optimization result of the second desired pattern image.

The updating of the first corrected result image includes, in a state in which parameters of the forward simulation neural network are fixed, adjusting parameters of the backward correction neural network so that the error between the first desired pattern image and the first simulated result image is reduced, the updating of the second corrected result image including, in a state in which the parameters of the forward simulation neural network are fixed, adjusting the parameters of the backward correction neural network so that the error between the second desired pattern image and the second simulated result image is reduced, and first parameter values of the backward correction neural network corresponding to the first finalized version are different from second parameter values of the backward correction neural network corresponding to the second finalized version.

The first process may include at least one of a develop process and an etch process.

In a general aspect, here is provided a non-transitory computer-readable storage medium storing instructions that, when executed by a processor, cause the processor to perform the method.

In a general aspect, here is provided an apparatus including a a processor configured to execute instructions and a memory storing the instructions, wherein execution of the plurality of instructions configures the processor to generate a first corrected result image of a first desired pattern image using a backward correction neural network provided a first input based on the first desired pattern image, the backward correction neural network performing a backward correction of a first process, generate a first simulated result image using a forward simulation neural network based on the first corrected result image, the forward simulation neural network performing a forward simulation of a performance of the first process, and update the first corrected result image so that an error between the first desired pattern image and the first simulated result image is reduced.

The processor may be configured to receive input pattern images corresponding to a simulation input of the first process and output pattern images corresponding to a simulation output of the first process, perform a first initial training on the forward simulation neural network based on the input pattern images and the output pattern images, to estimate the output pattern images from the input pattern images, and perform a second initial training on the backward correction neural network based on the input pattern images and the output pattern images, to estimate the input pattern images from the output pattern images.

To update the first corrected result image, the processor may be configured to, in a state in which parameters of the forward simulation neural network are fixed, adjust parameters of the backward correction neural network so that the error between the first desired pattern image and the first simulated result image is reduced.

To update the first corrected result image, the processor may be configured to, in a state in which the parameters of the forward simulation neural network and the parameters of the backward correction neural network are fixed, adjust pixels of the first corrected result image so that the error between the first desired pattern image and the first simulated result image is reduced.

To update the first corrected result image, the processor may be configured to update the first corrected result image based on gradient descent.

The processor may be configured to finalize the first corrected result image based on a first result of iteratively updating the first corrected result image, generate a second corrected result image of a second desired pattern image using the backward correction neural network provided a second input based on the second desired pattern image, generate a second simulated result image using the forward simulation neural network provided a third input based on the second corrected result image, and update the second corrected result image so that an error between the second desired pattern image and the second simulated result image is reduced.

The processor may be configured to finalize the second corrected result image based on a second result of iteratively updating the second corrected result image, a first finalized version of the first corrected result image corresponds to an individual optimization result of the first desired pattern image, and a second finalized version of the second corrected result image corresponds to an individual optimization result of the second desired pattern image.

To update the first corrected result image, the processor may be configured to, in a state in which parameters of the forward simulation neural network are fixed, adjust parameters of the backward correction neural network so that the error between the first desired pattern image and the first simulated result image is reduced, wherein, to update the second corrected result image, the processor may be configured to, in a state in which the parameters of the forward simulation neural network are fixed, adjust the parameters of the backward correction neural network so that the error between the second desired pattern image and the second simulated result image is reduced, and first parameter values of the backward correction neural network corresponding to the first finalized version are different from second parameter values of the backward correction neural network corresponding to the second finalized version.

The first process includes at least one of a develop process and an etch process.

In a general aspect, here is provided a processor-implemented method including training a neural backward model based on input pattern images corresponding to a simulation input of a target process, training a neural forward backward model based on output pattern images corresponding to a simulation output of the target process, generating, by the neural backward model, a corrected image based on a pattern image, generating, by the neural forward model, a simulated result image based on the corrected image, adjusting parameters of the neural backward model according to an error between the simulated result image and the pattern image.

The adjusting of the parameters may include iteratively updating the parameters to reduce the error to a predetermined threshold.

Other features and aspects will be apparent from the following detailed description, the drawings, and the claims.

BRIEF DESCRIPTION OF THE DRAWINGS

FIG. 1 illustrates an example semiconductor manufacturing process according to one or more embodiments.
FIG. 2 illustrates an example of a difference in develop process results according to one or more embodiments.
FIG. 3 illustrates an example forward simulation and backward correction in a semiconductor manufacturing process according to one or more embodiments.
FIG. 4 illustrates an example initialization process of a neural forward model and a neural backward model according to one or more embodiments.

FIG. 5 illustrates an example correction updating process using backward propagation according to one or more embodiments.

FIG. 6 illustrates an example process in which a corrected result image is indirectly updated through the updating of a neural backward model according to one or more embodiments.

FIG. 7 illustrates an example process in which a corrected result image is directly updated according to one or more embodiments.

FIG. 8 illustrates an example process in which a corrected result image for each desired pattern image is individually optimized according to one or more embodiments.

FIG. 9 illustrates an example neural correction method according to one or more embodiments.

FIG. 10 illustrates an example electronic apparatus according to one or more embodiments.

FIG. 11 illustrates an example electronic device with semiconductor pattern correction according to one or more embodiments.

Throughout the drawings and the detailed description, unless otherwise described or provided, the same, or like, drawing reference numerals may be understood to refer to the same, or like, elements, features, and structures. The drawings may not be to scale, and the relative size, proportions, and depiction of elements in the drawings may be exaggerated for clarity, illustration, and convenience.

DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences within and/or of operations described herein are merely examples, and are not limited to those set forth herein, but may be changed as will be apparent after an understanding of the disclosure of this application, except for sequences within and/or of operations necessarily occurring in a certain order. As another example, the sequences of and/or within operations may be performed in parallel, except for at least a portion of sequences of and/or within operations necessarily occurring in an order, e.g., a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Throughout the specification, when a component or element is described as being "on", "connected to," "coupled to," or "joined to" another component, element, or layer it may be directly (e.g., in contact with the other component or element) "on", "connected to," "coupled to," "joined", or "joined to" the other component, element, or layer or there may reasonably be one or more other components, elements, layers intervening therebetween. When a component or element is described as being "directly on", "directly connected to," "directly coupled to," or "directly joined" to another component or element, there can be no other elements intervening therebetween. Likewise, expressions, for example, "between" and "immediately between" and "adjacent to" and "immediately adjacent to" may also be construed as described in the foregoing.

The terminology used herein is for describing various examples only and is not to be used to limit the disclosure. The articles "a," "an," and "the" are intended to include the plural forms as well, unless the context clearly indicates otherwise. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof, or the alternate presence of an alternative stated features, numbers, operations, members, elements, and/or combinations thereof. Additionally, while one embodiment may set forth such terms "comprise" or "comprises," "include" or "includes," and "have" or "has" specify the presence of stated features, numbers, operations, members, elements, and/or combinations thereof, other embodiments may exist where one or more of the stated features, numbers, operations, members, elements, and/or combinations thereof are not present.

As used herein, the term "and/or" includes any one and any combination of any two or more of the associated listed items. The phrases "at least one of A, B, and C", "at least one of A, B, or C', and the like are intended to have disjunctive meanings, and these phrases "at least one of A, B, and C", "at least one of A, B, or C', and the like also include examples where there may be one or more of each of A, B, and/or C (e.g., any combination of one or more of each of A, B, and C), unless the corresponding description and embodiment necessitates such listings (e.g., "at least one of A, B, and C") to be interpreted to have a conjunctive meaning.

Due to manufacturing techniques and/or tolerances, variations of the shapes shown in the drawings may occur. Thus, the examples described herein are not limited to the specific shapes shown in the drawings but include changes in shape that occur during manufacturing.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

A neural network may be trained based on deep learning, and then perform inference for a desired purpose by mapping input data and output data that are in a nonlinear relationship to each other. The trained ability to generate such mapping may be referred to as a learning ability of the neural network.

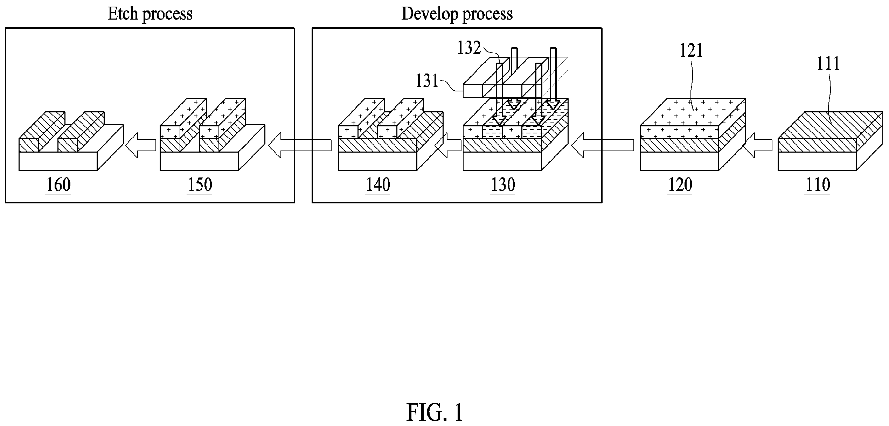

FIG. 1 illustrates an example semiconductor manufacturing process. Referring to FIG. 1, an example semiconductor manufacturing process may include various detailed processes for processing a wafer 111. A wafer may be manufactured in a first stage 110, and a photoresist 121 may be applied on the wafer 111 in a second stage 120.

In a third stage 130, light 132 may be irradiated to the photoresist 121 through a mask 131. There may be a pattern on the mask 131 through which the light 132 may pass to an exposed area of the photoresist 121. Thus, a pattern may be formed in the photoresist 121 based on the pattern of the mask 131. As the exposed area of the photoresist 121 is removed by the light 132, the pattern of the mask 131 may be formed on the photoresist 121 in a fourth stage 140. The third stage 130 and the fourth stage 140 may correspond to a develop process. An exposed area of the wafer 111 may be determined according to the pattern formed on the photoresist 121, and etching may be performed on the exposed area of the wafer 111 in a fifth stage 150. As the exposed area of the wafer 111 is removed, the pattern of the photoresist 121 may be formed on the wafer 111. In a sixth stage 160, the photoresist 121 may be removed. The fifth stage 150 and the sixth stage 160 may correspond to an etch process.

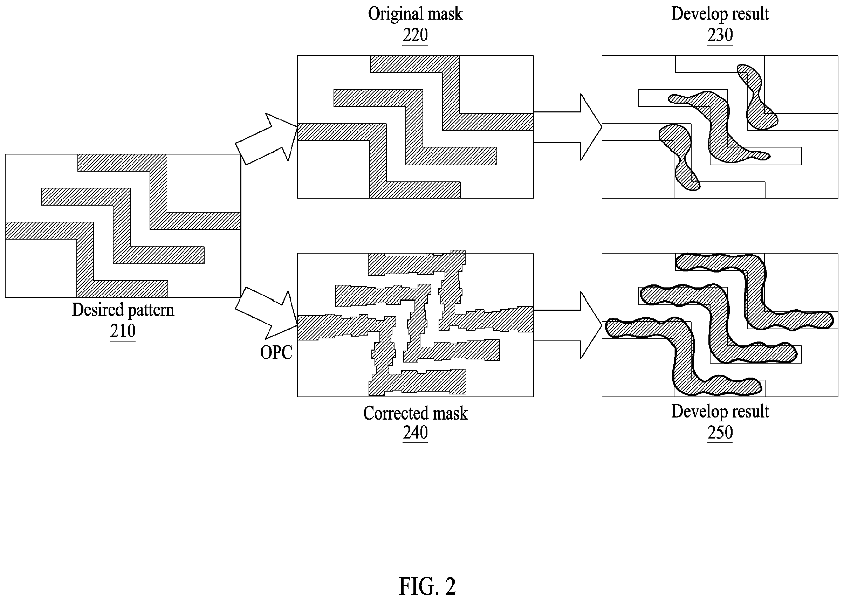

FIG. 2 illustrates an example difference in develop process results according to whether a correction is performed or not. In a typical semiconductor manufacturing process, when an original mask 220 that is shaped according to a desired pattern 210 is used, a develop result 230 with a large error from the desired pattern 210 may result due to the diffraction of light, process errors, and the like which may be generated during the develop process or the etch process. A correction may be made to the original mask 220 to reduce the error. A conventional correction approach for such an error prone develop process may include optical proximity correction (OPC), and a conventional correction approach for a corresponding error prone etch process may include process proximity correction (PPC).

FIG. 2 may correspond to an example of this OPC process. A corrected mask 240 may be determined according to OPC, and a develop result 250 with a small error may be derived from the corrected mask 240. The conventional correction approach may include fragmenting an initial mask, simulating a process result according to the initial mask, correcting fragments of the initial mask according to a predefined correction rule by referring to the simulation result to determine a new mask shape, and simulating a process result according to the new mask shape. According to the conventional correction approach, a final pattern may be derived through iterative displacement using a predefined correction rule.

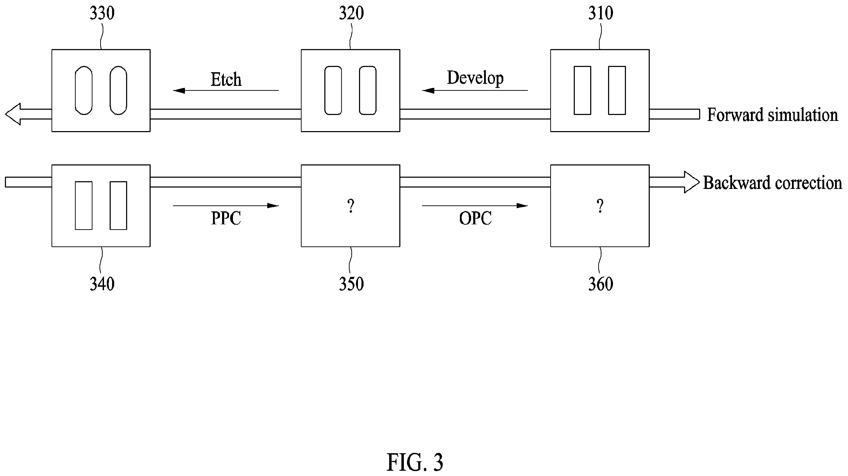

FIG. 3 illustrates an example forward simulation and backward correction approach in a typical semiconductor manufacturing process. Referring to FIG. 3, a second pattern image 320 may be determined through forward simulation of a develop process for a first pattern image 310, and a third pattern image 330 may be determined through forward simulation of an etch process for the second pattern image 320. For forward simulation, a simulation model considering various characteristics, conditions, variables, and the like of the typical semiconductor process may be used. For example, a change in shape that may occur in the develop process through forward simulation of the first pattern image 310 may be reflected in the first pattern image 310 to determine the second pattern image 320, and a change in shape that may occur in the etch process through forward simulation of the second pattern image 320 may be reflected in the second pattern image 320 to determine the third pattern image 330.

When an error occurs between the first pattern image 310 corresponding to a desired pattern and the third pattern image 330 corresponding to a result of the etch process, human intervention is required to perform backward correction to reduce the error. Such a conventional backward correction approach may include PPC for the etch process and OPC for the develop process. The conventional correction approach may be performed through a predefined correction rule. A fifth pattern image 350 may be generated according to PPC of a fourth pattern image 340. The fourth pattern image 340 may correspond to a desired pattern, and the fifth pattern image 350 may correspond to a corrected result for deriving the desired pattern according to the etch process. A sixth pattern image 360 may be generated according to OPC of the fifth pattern image 350. The sixth pattern image 360 may correspond to a corrected result for deriving the fifth pattern image 350 according to the develop process.

These PPC and OPC approaches are performed according to a predefined correction rule, which may be determined by humans, e.g., requiring human interaction to define the correction rule.

Rather, in one or more embodiments, pattern correction may be performed through an optimization technique based on a neural model and gradient descent without such human intervention and correction rules. In an example, optimization of pattern correction may be achieved even if a correction rule for each case is not prepared in advance. A neural network is a type of machine learning model, trained for a special purpose such as image restoration, may have a generalization ability to generate a relatively accurate output for an input pattern that the neural network wasn t trained for. For example, performed operations of a trained neural network may be retrained for inference operations.

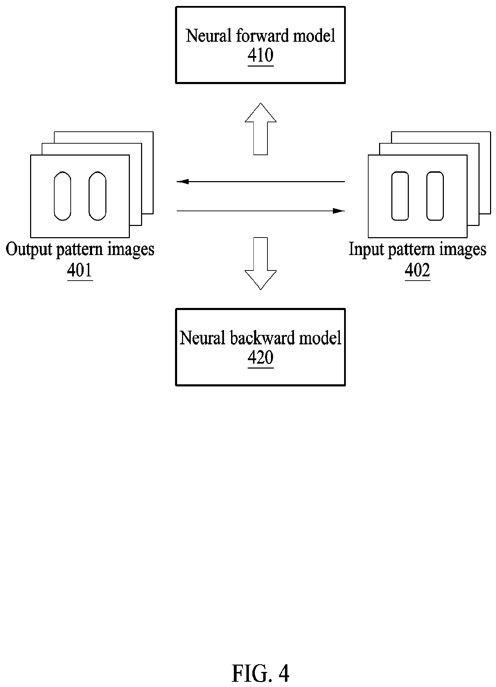

FIG. 4 illustrates an example of an initialization process of a neural forward model and a neural backward model according to one or more embodiments t. Referring to FIG. 4, in a non-limiting example, a neural forward model 410 and a neural backward model 420 may be trained based on output pattern images 401 and input pattern images 402. The input pattern images 402 may correspond to a simulation input of a target process, and the output pattern images 401 may correspond to a simulation output of a target process. The target process may include a develop process and/or an etch process.

The neural forward model 410 and the neural backward model 420 may include a neural network. The neural network may include a deep neural network (DNN) including a plurality of layers. The DNN may include any one or any combination of a fully connected network (FCN), a convolutional neural network (CNN), and a recurrent neural network (RNN). For example, at least a portion of the layers included in the neural network may correspond to a CNN, and another portion of the layers may correspond to an FCN. The CNN may be referred to as convolutional layers, and the FCN may be referred to as fully connected layers.

In an example, the neural network may be trained based on deep learning and perform operations of the neural network suitable for a training purpose, weights of the in-training neural networks may be iteratively adjusted through many passes with this training data. Deep learning is a machine learning technique, e.g., for neural network training. Deep learning may be understood as a process of iteratively adjusting the in-training neural network in a direction towards a point at which energy or loss is minimized. Through supervised or unsupervised learning of deep learning, a structure of the neural network or weights corresponding to a model may be obtained, the weights may be adjusted based on consideration of the output of the model, e.g., compared to a label or ground truth of a corresponding input to the model in a supervised learning process. When a width (e.g., extent of nodes of layers of the model) and a depth (e.g., the number of layers of the model) of the neural network are sufficiently large, the neural network may be trained sufficiently to implement a model trained for tasks. The neural network may achieve greater accuracy when learning a sufficiently large amount of training data through an appropriate training process.

In an example, the neural network may be considered as being trained in advance, where "in advance" means before the trained neural network is used for inference of unknown inputs, for example. Implementing the trained neural network may include the loading of parameters of the neural network from memory, a processor performing inference operations of the neural network for inputs provided to the neural network.

In an example, the neural forward model 410 may be pre-trained to perform forward simulation of the target process. The neural forward model 410 may be trained using the input pattern images 402 and the output pattern images 401 to estimate the output pattern images 401 from the input pattern images 402. The neural backward model 420 may be pre-trained to perform backward correction of the target process. The neural backward model 420 may be trained using the input pattern images 402 and the output pattern images 401 to estimate the input pattern images 402 from the output pattern images 401.

Given the input pattern images 402, the output pattern images 401 may be generated according to a simulation result of a simulation model. Forward simulation of the neural forward model 410 may have high accuracy when the simulation model has high simulation accuracy. An input of backward correction may have a different distribution than an input of forward simulation. For example, when a desired pattern image such as the third pattern image 340 of FIG. 3 is used as an input for backward correction, a distribution gap may exist between the output pattern images 401 and the desired pattern image. In an example, an error according to a distribution gap may be minimized based on gradient descent.

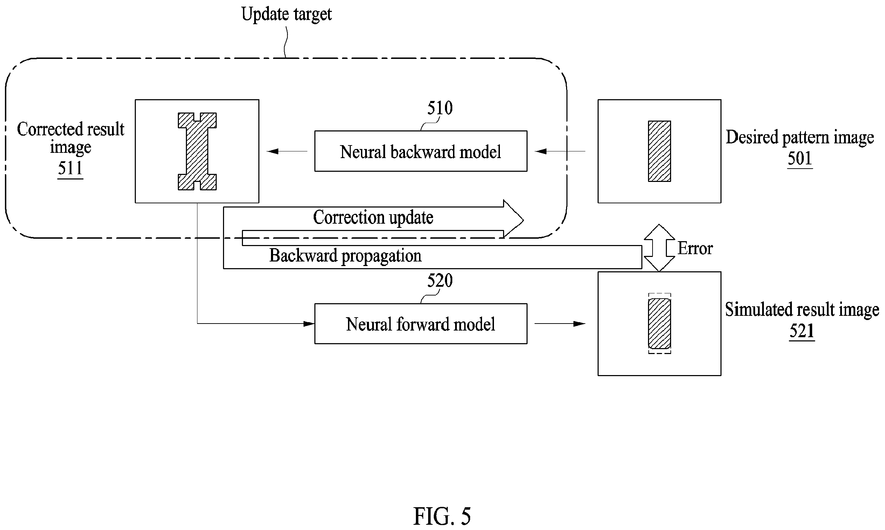

FIG. 5 illustrates an example of a correction updating process using backward propagation according to one or more embodiments. Referring to FIG. 5, a neural forward model 520 performing a forward simulation of a target process and a neural backward model 510 performing a backward correction of a target process are loaded. In an example, the neural backward model 510 and the neural forward model 520 may be trained based on input pattern images corresponding to a simulation input of the target process and output pattern images corresponding to a simulation output of the target process. To distinguish the training based on input pattern images and output pattern images from a correction optimization process based on gradient descent, the training based on input pattern images and output pattern images may be referred to as initial training.

After the initial training described above, the neural backward model 510 may generate a corrected result image 511 based on a desired pattern image 501. After initial training, the neural forward model 520 may generate a simulated result image 521 based on the corrected result image 511. Due to limitations of the initial training, an error may occur between the desired pattern image 501 and the simulated result image 521, and correction optimization may be performed to reduce the error.

Through the correction optimization, the corrected result image 511 may be updated. An update target for correction optimization may include the corrected result image 511 and the neural backward model 510. In an example, in a state in which the parameters of the neural backward model 510 and the parameters of the neural forward model 520 are fixed, e.g., unchanged, pixels of the corrected result image 511 may be directly adjusted in a direction of reducing an error. In an example, in a state in which the parameters of the neural forward model 520 are fixed, the parameters of the neural backward model 510 may be adjusted in a direction of reducing an error. The pixels of the corrected result image 511 may also be indirectly adjusted according to the adjustment of parameters of the neural backward model 510. The parameters may include network parameters such as a connection weight of the neural network. The direction of reducing an error may be determined according to a gradient descent. The corrected result image 511 may be finalized based on a result of iteratively updating the corrected result image 511.

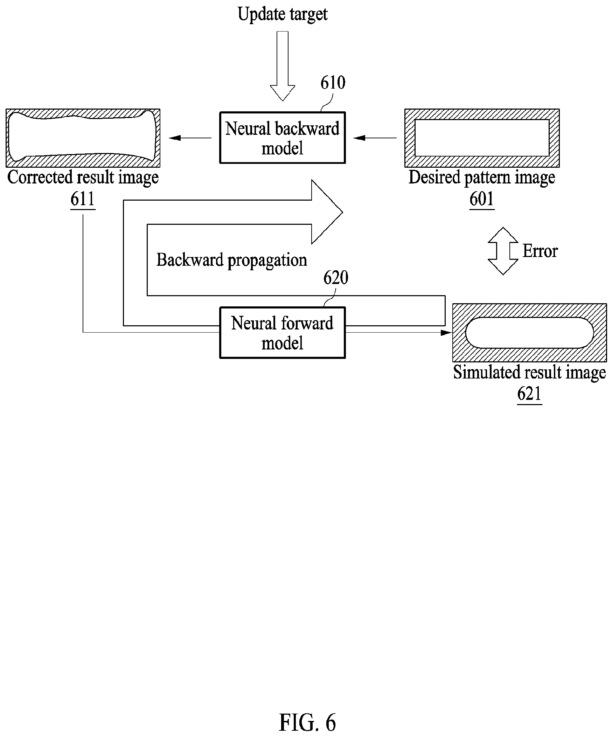

FIG. 6 illustrates an example process in which a corrected result image is indirectly updated through updating of a neural backward model according to one or more embodiments. Referring to FIG. 6, a neural backward model 610 may be executed based on a desired pattern image 601 to generate a corrected result image 611 of the desired pattern image 601. A neural forward model 620 may be executed based on the corrected result image 611 to generate a simulated result image 621. Prior to the corrected result image 611 and the simulated result image 621 being generated, the neural backward model 610 and the neural forward model 620 may be pre-trained through an initial training procedure. The neural backward model 610 and the neural forward model 620 may generate the corrected result image 611 and the simulated result image 621 using parameters pre-trained through the initial training procedure.

In an example, the corrected result image 611 may be updated so that an error between the desired pattern image 601 and the simulated result image 621 is reduced. The corrected result image 611 may be indirectly updated through an update of the neural backward model 610. In a state in which the parameters of the neural forward model 620 are fixed, the parameters of the neural backward model 610 may be adjusted so that an error between the desired pattern image 601 and the simulated result image 621 is reduced. The parameters of the neural backward model 610 may be adjusted based on Equation 1 below according to gradient descent.

Equation 1:

$$\theta_{t+1} = \theta_t - \eta \frac{\partial E}{\partial \theta}$$

In Equation 1, $\Theta$ denotes a parameter of the neural backward model 610, t denotes a time index, $\eta$ denotes a step size, and E denotes an error between the desired pattern image 601 and the simulated result image 621. A degree of update according to an increase in time t may be determined through $\eta$. When the update of the neural backward model 610 is sufficiently repeated or the error between the desired pattern image 601 and the simulated result image 621 is sufficiently reduced, the corrected result image 611 in the iterated state may be determined as a final version. When the target process is performed with a final corrected pattern of a final version of the corrected result image 611, a desired pattern of the desired pattern image 601 may be derived on the process result.

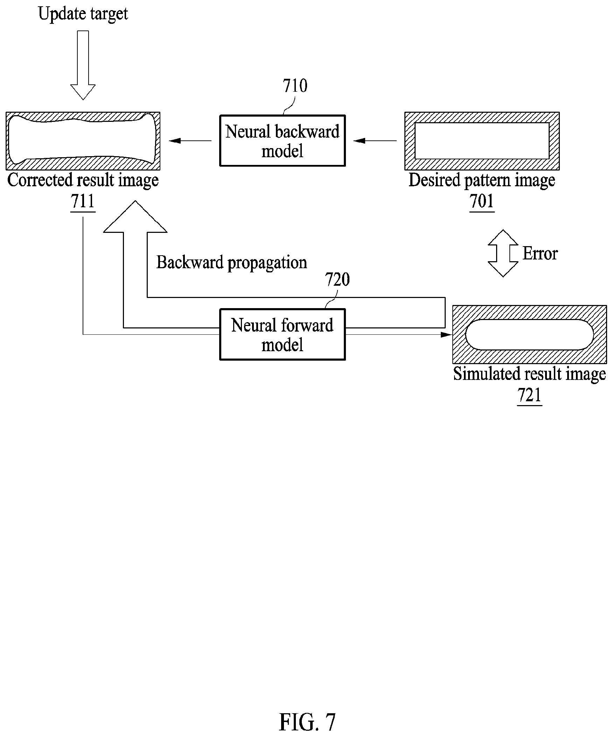

FIG. 7 illustrates an example process in which a corrected result image is directly updated according to one or more embodiments. Referring to FIG. 7, a neural backward model 710 may be executed based on a desired pattern image 701 to generate a corrected result image 711 of the desired pattern image 701. A neural forward model 720 may be executed based on the corrected result image 711 to generate a simulated result image 721. Prior to the corrected result image 711 and the simulated result image 721 being generated, the neural backward model 710 and the neural forward model 720 may be pre-trained through an initial training procedure. The neural backward model 710 and the neural forward model 720 may generate the corrected result image 711 and the simulated result image 721 using parameters pre-trained through the initial training procedure.

In an example, the corrected result image 711 may be updated so that an error between the desired pattern image 701 and the simulated result image 721 is reduced. The corrected result image 711 may be directly updated without updating the neural backward model 710. In a state in which the parameters of the neural forward model 720 and the parameters of the neural backward model 710 are fixed, pixels of the corrected result image 711 may be adjusted so that an error between the desired pattern image 701 and the simulated result image 721 is reduced. The pixels of the corrected result image 711 may be adjusted based on Equation 2 below according to gradient descent.

Equation 2:

$$\theta_{t+1} = \theta_t - \eta \frac{\partial E}{\partial \theta}$$

In Equation 2, θ denotes a parameter of the neural backward model 710, t denotes a time index, η denotes a step size, and E denotes an error between the desired pattern image 701 and the simulated result image 721. A degree of update according to an increase in time t may be determined through η. When the update of the corrected result image 711 is sufficiently repeated or the error between the desired pattern image 701 and the simulated result image 721 is sufficiently reduced, the corrected result image 711 in the iterated state may be determined as a final version. When the target process is performed with a final corrected pattern of a final version of the corrected result image 711, a desired pattern of the desired pattern image 701 may be derived on the process result.

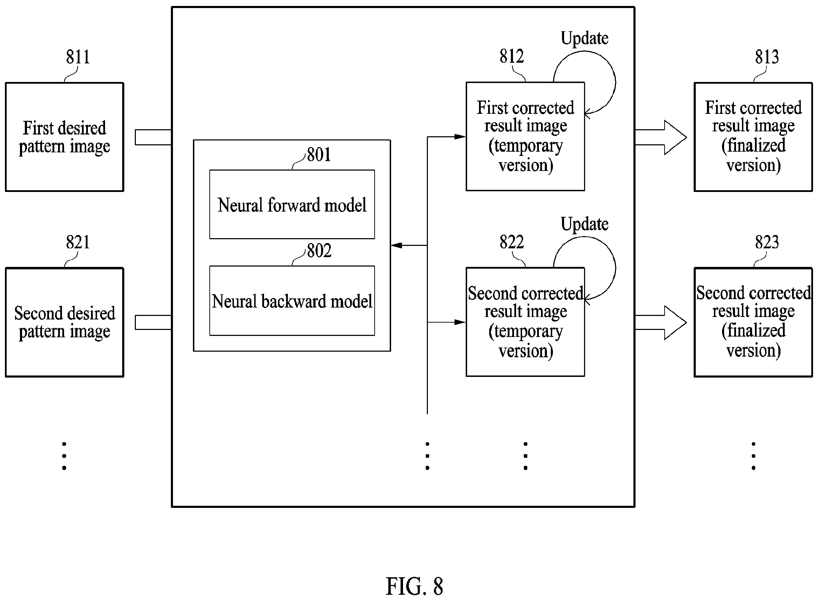

FIG. 8 illustrates an example process in which a corrected result image for each desired pattern image is individually optimized according to one or more embodiments. Correction optimization may be individually performed for each desired pattern image. Referring to FIG. 8, a first corrected result image 813 may be determined through individual correction optimization for a first desired pattern image 811, and a second corrected result image 823 may be determined through individual correction optimization for a second desired pattern image 821.

In an example, both a neural forward model 801 performing forward simulation of a target process for semiconductor manufacturing and a neural backward model 802 performing backward correction of the target process may be loaded. The neural forward model 801 and the neural backward model 802 may be trained based on input pattern images corresponding to a simulation input of the target process and output pattern images corresponding to a simulation output of the target process. The target process may include a develop process and/or an etch process.

In an example, the first corrected result image 813, may be based on the first desired pattern image 811, where the first corrected result image 813 may be generated using the neural forward model 801 and the neural backward model 802. More specifically, the neural backward model 802 may be executed based on the first desired pattern image 811 to generate a first corrected result image 812 for the first desired pattern image 811. The first corrected result image 812 may correspond to a temporary version, and the first corrected result image 813 may correspond to a finalized version.

Based on the first corrected result image 812, the neural forward model 801 may be executed to generate a first simulated result image. The first corrected result image 812 may be updated so that an error between the first desired pattern image 811 and the first simulated result image is reduced. The first corrected result image 812 may be directly or indirectly updated. The first corrected result image 813 may be finalized based on a result of iteratively updating the first corrected result image 812.

In an example, the second corrected result image 823 may be based on the second desired pattern image 821, where the second corrected result image 823 may be generated using the neural forward model 801 and the neural backward model 802. The neural backward model 802 may be executed based on the second desired pattern image 821 to generate a second corrected result image 822 of the second desired pattern image 821. The second corrected result image 822 may correspond to a temporary version, and the second corrected result image 823 may correspond to a finalized version.

Based on the second corrected result image 822, the neural forward model 801 may be executed to generate a second simulated result image. The second corrected result image 822 may be updated so that an error between the second desired pattern image 821 and the second simulated result image is reduced. The second corrected result image 822 may be directly or indirectly updated. The second corrected result image 823 may be finalized based on a result of iteratively updating the second corrected result image 822.

The first corrected result image 813, which is the finalized version, may correspond to an individual optimization result of the first desired pattern image 811. The second corrected result image 823, which is the finalized version, may correspond to an individual optimization result of the second desired pattern image 821. When the first corrected result image 813 and the second corrected result image 823 are indirectly optimized in the correction optimization process, that is, when the parameters of the neural backward model 802 are adjusted to reduce an error between the first desired pattern image 811 and the first simulated result image, when the parameters of the neural forward model 801 are fixed, and when the parameters of the neural backward model 802 are adjusted to reduce an error between the second desired pattern image 821 and the second simulated result image when the parameters of the neural forward model 801 are fixed, a first set of parameter values of the neural backward model 802 applied to the first corrected result image 813 may be different from a second set of parameter values of the neural backward model 802 applied to the second corrected result image 823.

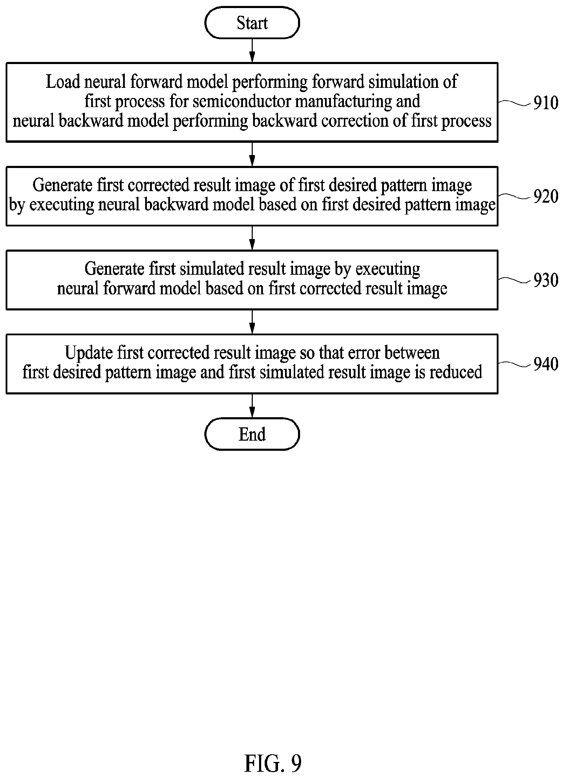

FIG. 9 illustrates an example neural correction method according to one or more embodiments. Referring to FIG. 9, a neural correction apparatus may load a neural forward model performing forward simulation of a first process for semiconductor manufacturing and a neural backward model performing backward correction of the first process in operation 910, generate a first corrected result image of a first desired pattern image by executing the neural backward model based on the first desired pattern image in operation 920, generate a first simulated result image by executing the neural forward model based on the first corrected result image in operation 930, and update the first corrected result image so that an error between the first desired pattern image and the first simulated result image is reduced in operation 940.

In an example, the neural correction apparatus may further perform the operations of receiving input pattern images corresponding to a simulation input of the first process and output pattern images corresponding to a simulation output of the first process, performing initial training of the neural forward model based on the input pattern images and the output pattern images so that the neural forward model estimates the output pattern images from the input pattern images, and performing initial training of the neural backward model based on the input pattern images and the output pattern images so that the neural backward model estimates the input pattern images from the output pattern images.

In an example, operation 940 may include, in a state in which the parameters of the neural forward model are fixed, adjusting the parameters of the neural backward model so that an error between the first desired pattern image and the first simulated result image is reduced.

Operation 940 may, in an example, include, in a state in which the parameters of the neural forward model and the parameters of the neural backward model are fixed, adjusting pixels of the first corrected result image so that an error between the first desired pattern image and the first simulated result image is reduced.

Operation 940 may also include updating the first corrected image based on gradient descent.

The neural correction apparatus may further perform the operations of finalizing the first corrected result image based on a result of iteratively updating the first corrected result image, generating a second corrected result image of a second desired pattern image by executing the neural backward model based on the second desired pattern image, generating a second simulated result image by executing the neural forward model based on the second corrected result image, and updating the second corrected result image so that an error between the second desired pattern image and the second simulated result image is reduced.

The neural correction apparatus may further perform an operation of finalizing the second corrected result image based on a result of iteratively updating the second corrected result image. The finalized version of the first corrected result image may correspond to an individual optimization result of the first desired pattern image, and the finalized version of the second corrected result image may correspond to an individual optimization result of the second desired pattern image.

In an example, the updating of the first corrected result image may include adjusting the parameters of the neural backward model so that an error between the first desired pattern image and the first simulated result image is reduced in a state in which the parameters of the neural forward model are fixed, and the updating of the second corrected result image may include adjusting the parameters of the neural backward model so that an error between the second desired pattern image and the second simulated result image is reduced in a state in which the parameters of the neural forward model are fixed, and parameter values of the neural backward model corresponding to the finalized version of the first corrected result image may be different from parameter values of the neural backward model corresponding to the finalized version of the second corrected result image.

The first process may include any one or any combination of a develop process and an etch process.

The descriptions provided with reference to FIGS. 1 to 8, 10, and 11 may apply to the neural correction method of FIG. 9.

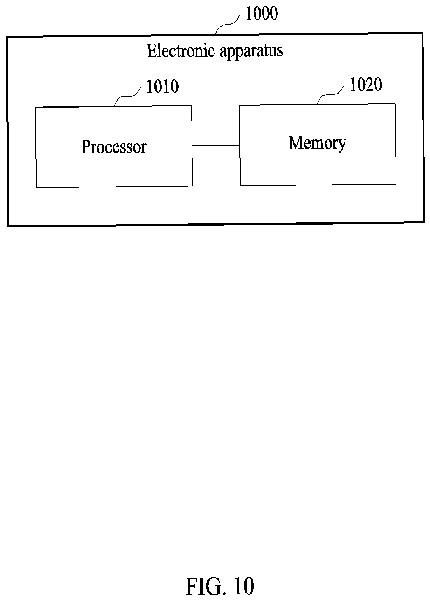

FIG. 10 illustrates an example configuration of an electronic apparatus according to one or more embodiments. Referring to FIG. 10, an electronic apparatus 1000 may include a processor 1010 and a memory 1020.

The processor 1010 may be configured to execute programs or applications to configure the processor 1010 to control the electronic apparatus 1000 to perform one or more or all operations and/or methods involving the correction of semiconductor mask patterns, and may include any one or a combination of two or more of, for example, a central processing unit (CPU), a graphic processing unit (GPU), a neural processing unit (NPU) and tensor processing units (TPUs), but is not limited to the above-described examples.

The memory 1020 may include computer-readable instructions. The processor 1010 may be configured to execute computer-readable instructions, such as those stored in the memory 1020, and through execution of the computer-readable instructions, the processor 1010 is configured to perform one or more, or any combination, of the operations and/or methods described herein. The memory 1010 may be a volatile or nonvolatile memory.

The processor 1010 may execute the instructions to perform the operations of FIGS. 1 to 9 and 11. For example, the processor 1010 may load a neural forward model performing forward simulation of a first process for semiconductor manufacturing and a neural backward model performing backward correction of the first process, generate a first corrected result image of a first desired pattern image by executing the neural backward model based on the first desired pattern image, generate a first simulated result image by executing the neural forward model based on the first corrected result image, and update the first corrected result image so that an error between the first desired pattern image and the first simulated result image is reduced. The descriptions provided above with reference to FIGS. 1 to 9, and 11 may apply to the description of the neural correction apparatus 1000.

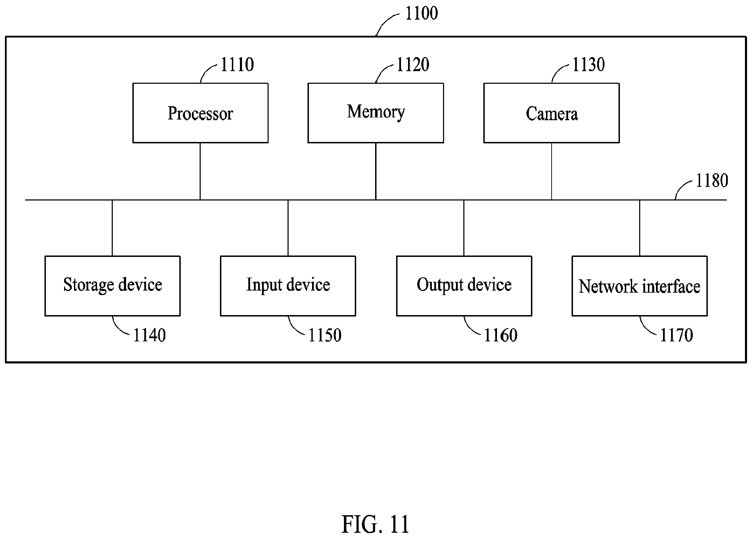

FIG. 11 illustrates an example configuration of an electronic device with semiconductor pattern correction according to one or more embodiments. Referring to FIG. 11, an electronic device 1100 may include a processor 1110, a memory 1120, a camera 1130, a storage device 1140, an input device 1150, an output device 1160, and a network interface 1170 that may communicate with each other through a communication bus 1180. For example, the electronic device 1100 may be, or included in, a mobile device such as a mobile phone, a smart phone, a personal digital assistant (PDA), a netbook, a tablet personal computer (PC) or a laptop computer, a wearable device such as a smart watch, a smart band or smart glasses, a computing device such as a desktop or a server, a home appliance such as a television (TV), a smart TV or a refrigerator, a security device such as a door lock, or a vehicle such as an autonomous vehicle or a smart vehicle. The electronic device 1100 may include, structurally and/or functionally through the processor 1110 performing the operations as discussed above with respect to FIG. 10, the electronic apparatus 1000 of FIG. 10.

The processor 1110 may execute computer-readable instructions. For example, the processor 1110 may process the instructions stored in the memory 1120 or the storage device 1140. The processor 1110 may perform the one or more operations described through FIGS. 1 to 10. In an example, when the processor 1110 executes the instructions, the processor 1110 may thereby be configured to perform one or more operations described herein. The memory 1120 may include a computer-readable storage medium or a computer-readable storage device. The memory 1120 may store instructions to be executed by the processor 1110 and may store information associated with software and/or applications when the software and/or applications are being executed by the electronic device 1100. The memory 1120 may further store the neural network described herein, e.g., including the respective parameters of the neural network.

The camera 1130 may capture a photo and/or a video. The storage device 1140 may include a computer-readable storage medium or computer-readable storage device. The storage device 1140 may store a greater amount of information than the memory 1120 and store the information for a long period of time. For example, the storage device 1140 may include a magnetic hard disk, an optical disc, a flash memory, a floppy disk, or other non-volatile memories known in the art.

The input device 1150 may receive an input from a user through traditional input methods such as a keyboard and a mouse, and through new input methods such as a touch input, a voice input, and an image input. For example, the input device 1150 may include a keyboard, a mouse, a touch screen, a microphone, or any other device that detects an input from the user and transmits the detected input to the electronic device 1100. The output device 1160 may provide an output of the electronic device 1100 to the user through a visual, auditory, or haptic channel. The output device 1160 may include, for example, a display, a touch screen, a speaker, a vibration generator, or any other device that provides the output to the user. The network interface 1170 may communicate with an external device through a wired or wireless network.

The processors, neural networks, memory, electronic device, electronic device 1000, processor 1010, memory 1020, electronic device 1100, processor 1110, memory 1120, camera 1130, storage device 1140, input device 1150, output device 1160, network interface 1170, neural forward model 410, and neural backward model 420, described herein and disclosed herein described with respect to FIGS. 1-11 are implemented by or representative of hardware components. As described above, or in addition to the descriptions above, examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. As described above, or in addition to the descriptions above, example hardware components may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-11 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media, and thus, not a signal per se. As described above, or in addition to the descriptions above, examples of a non-transitory computer-readable storage medium include one or more of any of read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD-Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks , and/or any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

For example, the following clauses also fall into the scope of the disclosure.

Clause 1. A processor-implemented method, the method comprising training a backward correction neural network based on input pattern images corresponding to a simulation input of a target process; training a forward simulation neural network based on output pattern images corresponding to a simulation output of the target process; generating, by the backward correction neural network, a corrected image based on a pattern image; generating, by the forward simulation neural network, a simulated result image based on the corrected image; and adjusting parameters of the backward correction neural network according to an error between the simulated result image and the pattern image.

Clause 2. The method of clause 1, wherein the adjusting of the parameters comprises iteratively updating the parameters to reduce the error to a predetermined threshold.

**Claims**

1. A processor-implemented method, the method comprising:

   generating a first corrected result image of a first desired pattern image using a backward correction neural network based on the first desired pattern image, the backward correction neural network performing a backward correction of a first process;
   generating a first simulated result image by executing a forward simulation neural network based on the first corrected result image, the forward simulation neural network performing a forward simulation of a performance of the first process; and
   updating the first corrected result image so that an error between the first desired pattern image and the first simulated result image is reduced.

2. The method of claim 1, further comprising:

   receiving input pattern images corresponding to a simulation input of the first process and output pattern images corresponding to a simulation output of the first process;
   performing a first initial training on the forward simulation neural network, based on the input pattern images and the output pattern images so that the forward simulation neural network estimates the output pattern images from the input pattern images; and
   performing a second initial training on the backward correction neural network based on the input pattern images and the output pattern images so that the backward correction neural network estimates the input pattern images from the output pattern images.

3. The method of any of the preceding claims, wherein the updating of the first corrected result image comprises:

   in a state in which parameters of the forward simulation neural network are fixed, adjusting parameters of the backward correction neural network so that the error between the first desired pattern image and the first simulated result image is reduced,
   wherein the updating of the first corrected result image preferably comprises:
   in a state in which the parameters of the forward simulation neural network and the parameters of the backward correction neural network are fixed, adjusting pixels of the first corrected result image so that the error between the first desired pattern image and the first simulated result image is reduced.

4. The method of any of the preceding claims, wherein the updating of the first corrected result image comprises updating the first corrected result image based on gradient descent.

5. The method of any of the preceding claims, further comprising:

   finalizing the first corrected result image based on a first result of iteratively updating the first corrected result image;
   generating a second corrected result image of a second desired pattern image using the backward correction neural network provided a first input based on the second desired pattern image;
   generating a second simulated result image using the forward simulation neural network provided a second input based on the second corrected result image; and
   updating the second corrected result image so that an error between the second desired pattern image and the second simulated result image is reduced,
   the method preferably further comprising:
   finalizing the second corrected result image based on a second result of iteratively updating the second corrected result image, wherein a first finalized version of the first corrected result image corresponds to an individual optimization result of the first desired pattern image, and wherein a second finalized version of the second corrected result image corresponds to an individual optimization result of the second desired pattern image.

6.  The method of claim 5, wherein the updating of the first corrected result image comprises:

    in a state in which parameters of the forward simulation neural network are fixed, adjusting parameters of the backward correction neural network so that the error between the first desired pattern image and the first simulated result image is reduced,

    wherein the updating of the second corrected result image comprises:

    in a state in which the parameters of the forward simulation neural network are fixed, adjusting the parameters of the backward correction neural network so that the error between the second desired pattern image and the second simulated result image is reduced, and

    wherein first parameter values of the backward correction neural network corresponding to the first finalized version are different from second parameter values of the backward correction neural network corresponding to the second finalized version.

7.  The method of any of the preceding claims, wherein the first process comprises at least one of a develop process and an etch process.

8.  A non-transitory computer-readable storage medium storing instructions that, when executed by a processor, cause the processor to perform the method of any of the preceding claims.

9.  An apparatus, comprising:

    a processor configured to execute instructions; and

    a memory storing the instructions, wherein execution of the instructions configures the processor to:

    generate a first corrected result image of a first desired pattern image using a backward correction neural network provided a first input based on the first desired pattern image, the backward correction neural network performing a backward correction of a first process;

    generate a first simulated result image using a forward simulation neural network based on the first corrected result image, the forward simulation neural network performing a forward simulation of a performance of the first process; and

    update the first corrected result image so that an error between the first desired pattern image and the first simulated result image is reduced.

10. The apparatus of claim 9, wherein the processor is configured to:

    receive input pattern images corresponding to a simulation input of the first process and output pattern images corresponding to a simulation output of the first process;

    perform a first initial training on the forward simulation neural network based on the input pattern images and the output pattern images so that the forward simulation neural network estimates the output pattern images from the input pattern images; and

    perform a second initial training on the backward correction neural network based on the input pattern images and the output pattern images so that the backward correction neural network estimates the input pattern images from the output pattern images.

11. The apparatus of claim 9 or 10, wherein, to update the first corrected result image, the processor is configured to:

    in a state in which parameters of the forward simulation neural network are fixed, adjust parameters of the backward correction neural network so that the error between the first desired pattern image and the first simulated result image is reduced,

    wherein, to update the first corrected result image, the processor is preferably configured to: in a state in which the parameters of the forward simulation neural network and the parameters of the backward correction neural network are fixed, adjust pixels of the first corrected result image so that the error between the first desired pattern image and the first simulated result image is reduced.

12. The apparatus of any of the claims 9-11, wherein, to update the first corrected result image, the processor is configured to:
    update the first corrected result image based on gradient descent.

13. The apparatus of any of the claims 9-12, wherein the processor is configured to:

    finalize the first corrected result image based on a first result of iteratively updating the first corrected result image;

    generate a second corrected result image of a second desired pattern image using the backward correction neural network provided a second input based on the second desired pattern image;

generate a second simulated result image using the forward simulation neural network provided a third input based on the second corrected result image; and

update the second corrected result image so that an error between the second desired pattern image and the second simulated result image is reduced,

wherein the processor is preferably configured to finalize the second corrected result image based on a second result of iteratively updating the second corrected result image, wherein a first finalized version of the first corrected result image corresponds to an individual optimization result of the first desired pattern image, and wherein a second finalized version of the second corrected result image corresponds to an individual optimization result of the second desired pattern image.

14. The apparatus of claim 13, wherein, to update the first corrected result image, the processor is configured to:

in a state in which parameters of the forward simulation neural network are fixed, adjust parameters of the backward correction neural network so that the error between the first desired pattern image and the first simulated result image is reduced,

wherein, to update the second corrected result image, the processor is configured to:

in a state in which the parameters of the forward simulation neural network are fixed, adjust the parameters of the backward correction neural network so that the error between the second desired pattern image and the second simulated result image is reduced, and

wherein first parameter values of the backward correction neural network corresponding to the first finalized version are different from second parameter values of the backward correction neural network corresponding to the second finalized version.

15. The apparatus of any of the claims 9-14, wherein the first process comprises at least one of a develop process and an etch process.

Etch process          Develop process

132

131

160          150          140          130          120          110

121          111

FIG. 1

EP 4 386 481 A1

Desired pattern
210

Original mask
220

Develop result
230

OPC

Corrected mask
240

Develop result
250

FIG. 2

FIG. 3

FIG. 4

Update target

FIG. 5

Update target

610

Neural backward model

Corrected result image
611

Desired pattern image
601

Backward propagation

620

Error

Neural forward model

Simulated result image
621

FIG. 6

Update target

710

Neural backward
model

Corrected result image
711

Desired pattern image
701

Error

Backward propagation

720

Neural forward
model

Simulated result image
721

FIG. 7

FIG. 8



- 811 First desired pattern image
- 821 Second desired pattern image
- 801 Neural forward model
- 802 Neural backward model
- 812 First corrected result image (temporary version) — Update
- 822 Second corrected result image (temporary version) — Update
- 813 First corrected result image (finalized version)
- 823 Second corrected result image (finalized version)

EP 4 386 481 A1

```
        ┌─────────────┐
        │    Start    │
        └─────────────┘
               │
               ▼
┌────────────────────────────────────────────────────┐
│  Load neural forward model performing forward       │
│  simulation of first process for semiconductor      │──── 910
│  manufacturing and neural backward model performing │
│  backward correction of first process              │
└────────────────────────────────────────────────────┘
               │
               ▼
┌────────────────────────────────────────────────────┐
│  Generate first corrected result image of first     │
│  desired pattern image by executing neural backward │──── 920
│  model based on first desired pattern image         │
└────────────────────────────────────────────────────┘
               │
               ▼
┌────────────────────────────────────────────────────┐
│  Generate first simulated result image by executing │
│  neural forward model based on first corrected      │──── 930
│  result image                                       │
└────────────────────────────────────────────────────┘
               │
               ▼
┌────────────────────────────────────────────────────┐
│  Update first corrected result image so that error  │
│  between first desired pattern image and first      │──── 940
│  simulated result image is reduced                  │
└────────────────────────────────────────────────────┘
               │
               ▼
        ┌─────────────┐
        │     End     │
        └─────────────┘
```

FIG. 9

FIG. 10

1100

| 1110 | 1120 | 1130 |
| --- | --- | --- |
| Processor | Memory | Camera |

1180

| 1140 | 1150 | 1160 | 1170 |
| --- | --- | --- | --- |
| Storage device | Input device | Output device | Network interface |

FIG. 11

25

Europäisches
Patentamt

European
Patent Office

Office européen
des brevets

# EUROPEAN SEARCH REPORT

Application Number

EP 23 19 5161

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2020/193095 A1 (ASML NETHERLANDS BV [NL]) 1 October 2020 (2020-10-01) | 1-3, 7-11,15 | INV. G03F7/00 |
| Y | * paragraph [0074] – paragraph [0224] * * figures 4,5,21,22 * | 4-6, 12-14 | |
| Y | WO 2020/200993 A1 (ASML NETHERLANDS BV [NL]) 8 October 2020 (2020-10-08) | 4,12 | |
| A | * paragraphs [0088], [0108] * | 1,8,9 | |
| Y | WO 2022/179802 A1 (ASML NETHERLANDS BV [NL]) 1 September 2022 (2022-09-01) | 5,6,13, 14 | |
| A | * paragraph [0089]; figure 8 * | 1,8,9 | |

TECHNICAL FIELDS
SEARCHED      (IPC)

G03F

The present search report has been drawn up for all claims

| Place of search | Date of completion of the search | Examiner |
|---|---|---|
| Munich | 14 March 2024 | Meixner, Matthias |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.............................................................................
& : member of the same patent family, corresponding
    document

EPO FORM 1503 03.82 (P04C01)

**EP 4 386 481 A1**

## ANNEX TO THE EUROPEAN SEARCH REPORT
## ON EUROPEAN PATENT APPLICATION NO.

EP 23 19 5161

This annex lists the patent family members relating to the patent documents cited in the above-mentioned European search report.
The members are as contained in the European Patent Office EDP file on
The European Patent Office is in no way liable for these particulars which are merely given for the purpose of information.

14-03-2024

| Patent document cited in search report | | Publication date | Patent family member(s) | | Publication date |
|---|---|---|---|---|---|
| WO 2020193095 | A1 | 01-10-2020 | CN | 113892059 A | 04-01-2022 |
| | | | JP | 7256287 B2 | 11-04-2023 |
| | | | JP | 2022524970 A | 11-05-2022 |
| | | | JP | 2023089034 A | 27-06-2023 |
| | | | KR | 20210130784 A | 01-11-2021 |
| | | | TW | 202043938 A | 01-12-2020 |
| | | | TW | 202206950 A | 16-02-2022 |
| | | | TW | 202316203 A | 16-04-2023 |
| | | | US | 2022179321 A1 | 09-06-2022 |
| | | | WO | 2020193095 A1 | 01-10-2020 |
| WO 2020200993 | A1 | 08-10-2020 | CN | 113661447 A | 16-11-2021 |
| | | | KR | 20210134376 A | 09-11-2021 |
| | | | US | 2022187713 A1 | 16-06-2022 |
| | | | WO | 2020200993 A1 | 08-10-2020 |
| WO 2022179802 | A1 | 01-09-2022 | CN | 114972056 A | 30-08-2022 |
| | | | EP | 4298478 A1 | 03-01-2024 |
| | | | KR | 20230147096 A | 20-10-2023 |
| | | | TW | 202303264 A | 16-01-2023 |
| | | | WO | 2022179802 A1 | 01-09-2022 |

EPO FORM P0459

For more details about this annex : see Official Journal of the European Patent Office, No. 12/82